# EUROPÄISCHE PATENTSCHRIFT

(11) **EP 0 631 305 B1**
(45) Veröffentlichungstag und Bekanntmachung des Hinweises auf die Patenterteilung: **15.04.1998**
(21) Anmeldenummer: 94108802.3
(22) Anmeldetag: 08.06.1994
(51) Int. Cl.: H01L 21/76, H01L 21/225

(54) **Verfahren zur Herstellung eines Isolationsgrabens in einem Substrat für Smart-Power-Technologien**
Process for manufacturing un isolation region in a substrate for smart-power-technology
Procédé de fabrication d'une région d'isolation dans un substrat pour la technologie de puissance intélligente

(30) Priorität: 23.06.1993 DE 4320884
(43) Veröffentlichungstag der Anmeldung: 28.12.1994
(73) Patentinhaber: SIEMENS AKTIENGESELLSCHAFT, 80333 München (DE)
(72) Erfinder: Schwalke, Udo, Dr., D-84432 Heldenstein (DE)

(56) Entgegenhaltungen:
- EP-A- 0 259 605
- EP-A- 0 296 754
- WO-A-85/04760
- WO-A-86/03620
- WO-A-86/04454
- US-A- 4 666 556
- EXTENDED ABSTRACTS OF THE 20TH (1988 INTERNATIONAL ) CONFERENCE ON SOLID STATE DEVICES ANS MATERIALS TOKYO 1988, 1988, TOKYO Seiten 33 - 36 A. NAKAGAWA ET AL. '500 V LATERAL DOUBLE GATE BIPOLAR-MODE MOSFET(DGIGBT) DIELECTRICALLY ISOLATED BY SILICON WAFER DIRECT-BONDING (DISDB)'
- IBM TECHNICAL DISCLOSURE BULLETIN., Bd.27, Nr.10A, März 1985, NEW YORK US Seiten 5501 - 5504 'SIDEWALL CHANNEL-STOP DOPING FOR DEEP-TRENCH ISOLATION OF FET DEVICES'
- JOURNAL OF THE ELECTROCHEMICAL SOCIETY, Bd.139, Nr.6, Juni 1992, MANCHESTER, NEW HAMPSHIRE US Seiten 1690 - 1692 K. FUJINO ET AL. 'SURFACE MODIFICATION OF BASE MATERIALS FOR TEOS/O3 ATMOSPHERIC PRESSURE CHEMICAL VAPOR DEPOSITION.'

## Beschreibung

Unter Smart-Power-Technologie versteht man die monolithische Integration komplexer Logikbauelemente mit Hochspannungs-Leistungsbauelementen in einem Substrat. Da die Logikbauelemente mit Spannungspegeln um 5 Volt betrieben werden, bei den Hochspannungs-Leistungsbauelementen jedoch Spannungen bis zu 500 Volt auftreten, ist eine elektrische Trennung der Hochspannungsbauelemente von den Logikbauelementen erforderlich.

Es ist bekannt (siehe zum Beispiel Yu Ohata et al, IEEE 1987 CICC, S. 443 bis 446), die Hoch- und Niederspannungsbauelemente durch dielektrische Isolation elektrisch vollständig gegeneinander zu isolieren. Dabei werden die Bauelemente in einem SOI-Substrat realisiert. Ein SOI-Substrat umfaßt auf einer einkristallinen Siliziumscheibe eine isolierende Schicht aus SiO₂ und auf der isolierenden Schicht eine einkristalline Siliziumschicht, die die Oberfläche des SOI-Substrats umfaßt. Die isolierende Schicht des SOI-Substrats stellt die vertikale Isolation sicher, während die laterale Isolation der Bauelemente durch mit isolierendem Material gefüllte Gräben realisiert wird. Für viele Anwendungen wird das Spannungsverhalten der Bauelemente dadurch verbessert, daß vor dem Auffüllen der Gräben mit Oxid die Seitenwände der Gräben über die gesamte Tiefe bis zur isolierenden Schicht des SOI-Materials n⁺- oder p⁺-dotiert werden (siehe N. Yasuhara et al, IEDM 1991, S. 141 bis 144).

In Extended abstracts of the 20th (1988 international) conference on solid-state devices and materials, Tokio 1988, Seiten 33 bis 36 ist vorgeschlagen worden, die Seitenwände der Gräben durch Gasdiffusion zu dotieren und die Gräben durch eine thermische Oxidation mit einer Isolationsstruktur zu versehen.

Zur Herstellung der lateralen Isolierung ist es bekannt, nach der Ätzung des Grabens zunächst die Dotierung der Seitenwände durchzuführen. Diese Dotierung erfolgt zum Beispiel durch Ausdiffusion aus dotierten Gläsern wie BSG oder PSG, durch Belegung aus der Gasphase oder durch Ionenimplantation. Anschließend wird der Graben mit SiO₂ aufgefüllt. Dieses erfolgt zum Beispiel durch thermische Oxidation oder durch CVD-Abscheidung von SiO₂.

Da in Smart-Power-Technologien Grabentiefen um 20 µm mit Aspektverhältnissen (das ist der Quotient Grabentiefe zu Grabenbreite) von 5 bis 10 auftreten, ist es problematisch, durch Ionenimplantation bei der Dotierung der Seitenwände ein Diffusionsgebiet mit einer gleichförmigen, vorgebbaren Ausdehnung herzustellen. Die Ionenimplantation muß gewinkelt durchgeführt werden, wobei das Substrat viermal gedreht werden muß, um eine einigermaßen gleichmäßige Dotierstoffkonzentration an allen Wänden sicherzustellen. Da Dosen von mindestens 5 x 10¹⁵ Atome/cm² notwendig sind, ist dieses Verfahren zeitlich sehr aufwendig.

Bei der Dotierung durch Ausdiffusion aus Gläsern oder Belegung aus der Gasphase muß nach der Bildung des Diffusionsgebietes die Schicht aus dotiertem Glas oder die Belegungsschicht wieder entfernt werden, um eine unkontrollierte Ausdiffusion aus diesen Schichten oder eine Kontamination des Equipments im weiteren Prozeßablauf zu vermeiden. Die als Dotierquellen verwendeten Schichten müssen daher restefrei entfernt werden. Da diese Schichten SiO₂-artig sind und am Boden des Grabens unmittelbar auf der isolierenden Schicht des SOI-Substrats angeordnet sind, besteht am Boden des Grabens kein Ätzstop. Beim restefreien Entfernen dieser Schichten kommt es daher zu einem Angriff auf die isolierende Schicht des SOI-Substrats. Wird der Graben anschließend durch thermische Oxidation mit SiO₂ aufgefüllt, führt ein An- oder Durchätzen der isolierenden Schicht zur Ausbildung von Hohlräumen, die nicht mehr aufgefüllt werden können. Wird der Graben unter Verwendung von CVD-SiO₂ aufgefüllt, muß entweder eine ungenügende Konformität der Abscheidung bei Atmosphärendruck oder eine sehr geringe Abscheiderate bei Niederdruckabscheidung in Kauf genommen werden.

Aus EP-A-0 259 605 ist ein Verfahren zum Erzeugen einer definierten Dotierung in Seitenwänden und Böden von in Halbleitersubstrate eingeätzten Gräben bekannt. Dabei wird in den Gräben eine Belegungsschicht aus Borsilikatglas durch thermische Zersetzung aus der Gasphase von organischen Silizium, Sauerstoff und Bor enthaltenden Verbindungen abgeschieden. Nach einer Ausdiffusion wird die Belegungsschicht durch Ätzen entfernt. Dieses Verfahren zeichnet sich durch eine gute Kantenbedeckung der Belegungsschicht aus, durch die eine Dünnung der Belegungsschicht an kritischen Stellen vermieden wird und somit für eine gleichmäßige Stärke der Dotierstoffquelle gesorgt wird.

Aus EP 0 296 754 A2 ist bekannt, zur Vermeidung von Spannungen beim Auffüllen von Gräben in SOI-Substraten zunächst durch thermische Oxidation an der Oberfläche der Siliziumschicht des SOI-Substrats eine dünne Oxidschicht zu bilden. Anschließend wird eine Schicht aus Polysilizium abgeschieden und oxidiert. Bei der Ätzung der Gräben wird die isolierende Schicht des SOI-Substrates angegriffen. Das weggeätzte Teil dieser isolierenden Schicht wird durch Aufoxidation der Siliziumschicht zum großen Teil ersetzt.

Aus US-PS 4 666 556 ist bekannt, zur Erzeugung einer ätzresistenten Siliziumdioxidschicht auf der Oberfläche eines Grabens, der in einem Siliziumsubstrat gebildet ist, eine Siliziumoxidschicht, eine Siliziumnitridschicht und eine konforme Schicht aus Polysilizium abzuscheiden, aus der konformen Schicht Spacer zu bilden und diese durch thermische Oxidation in Siliziumdioxid zu verwandeln.

Aus WO-A- 85 04 760 ist bekannt, zur Erzeugung von dotierten Gebieten in Seitenwänden von Gräben in Siliziumsubstraten eine Polysiliziumschicht abzuscheiden. Im oberen Bereich des Grabens und am Boden des Grabens wird die Polysiliziumschicht anschließend durch Implantation dotiert. Es wird ein Temperschritt durchgeführt, bei dem die Dotierstoffe innerhalb der Polysiliziumschicht diffundieren und sich gleichmäßig verteilen. Schließlich wird ein weiterer Temperschritt durchgeführt, bei dem die Polysiliziumschicht oxidiert wird.

Aus Journal Of The Electrochemical Society, Bd. 139, Nr. 6, Juni 1992, Seiten 1690 bis 1692, ist ein Verfahren zur Abscheidung von SiO₂ unter Verwendung von TEOS und O₃ in einem CVD-Verfahren bekannt.

Der Erfindung liegt das Problem zugrunde, ein Verfahren zur Herstellung von einem Isolationsgraben in einem SOI-Substrat, in dem Logikbauelemente und Hochspannungs-Leistungsbauelemente integriert sind, anzugeben, mit dem in den Seitenwänden des Grabens Diffusionsgebiete definierter Ausdehnung herstellbar sind und mit dem der Graben auch im Fall eines Durchätzens der isolierenden Schicht des SOI-Substrats lunkerfrei aufgefüllt werden kann.

Dieses Problem wird erfindungsgemäß gelost durch ein Verfahren nach Anspruch 1. In dem erfindungsgemäßen Verfahren werden dem Graben benachbarte Diffusionsgebiete in der monokristallinen Siliziumschicht durch Ausdiffusion aus einer den Dotierstoff enthaltenden Belegungsschicht, die auf die Seitenwände des Grabens aufgebracht wird, gebildet. Nach der Ausdiffusion wird die Belegungsschicht vollständig entfernt. Anschließend wird eine Siliziumschicht aufgebracht. Durch thermische Oxidation wird im Graben eine Isolationsstruktur erzeugt. Da es bei der Oxidation von Silizium zu einer Volumenexpansion um einen Faktor von etwa 2 kommt, braucht die Dicke der Siliziumschicht höchstens ein Viertel der Breite des Grabens zu betragen. Die Siliziumschicht wird insbesondere amorph in einem LPCVD-Verfahren abgeschieden. Die Siliziumschicht kann auch polykristallin erzeugt werden. Amorphes Silizium weist jedoch eine feinere Struktur als polykristallines Silizium auf und führt daher zu einer besseren Konformität in der Kantenbedeckung.

In dem erfindungsgemäßen Herstellverfahren ist selbst ein vollständiges Durchätzen der isolierenden Schicht des SOI-Substrats, wie es für ein restefreies Entfernen von dotierten Gläsern benötigt werden kann, unkritisch, weil das weggeätzte Isolationsoxid durch Aufoxidation der Siliziumschicht zum großen Teil ersetzt wird. Daher können in dem erfindungsgemäßen Verfahren unter Atmosphärendruck abgeschiedene dotierte Gläser, wie zum Beispiel BPSG, für die Belegungsschicht verwendet werden. Diese dotierten Gläser werden in der CMOS-Fertigung standardmäßig zur Planarisierung verwendet. In Form von BSG oder PSG sind diese dotierten Gläser als Diffusionsquellen geeignet. Bei Aspektverhältnissen, wie sie bei Isolationsgraben in Smart-Power-Technologien auftreten zeigen diese APCVD-Glaser eine schlechte Konformität. Daher kommt es bei Verwendung dieser Gläser als Belegungsschicht beim vollständigen Entfernen der Belegungsschicht zum Durchätzen der isolierenden Schicht des SOI-Substrats.

Es liegt im Rahmen der Erfindung, nach dem Entfernen der Belegungsschicht eine SiO₂-Schicht und/oder Si₃N₄-Schicht mit im wesentlichen konformer Kantenbedeckung zu erzeugen, auf deren Oberfläche die Siliziumschicht aufgebracht wird. Anschließend wird die Siliziumschicht in einem anisotropen Ätzprozeß selektiv zu SiO₂ bzw. Si₃ N₄ geätzt, wobei waagrechte Flächen der SiO₂ bzw. Si₃N₄-Schicht freigelegt werden. Dabei entstehen an senkrechten Flanken der monokristallinen Siliziumschicht des SOI-Substrats Siliziumspacer. Bei der thermischen Oxidation werden diese Siliziumspacer oxidiert und quellen durch Volumenexpansion auf. Gleichzeitig wird derjenige Anteil der SiO₂-Schicht, der am Boden des Grabens angeordnet ist, verstärkt.

Bei der Oxidation des Siliziumspacers entsteht eine Isolationsstruktur, in der zwischen gegenüberliegenden Flanken ein Freiraum verbleibt.

Es liegt im Rahmen der Erfindung, diesen Freiraum durch Abscheiden und Rückätzen einer weiteren Siliziumschicht mit einer Siliziumfüllung aufzufüllen.

Alternativ kann der Freiraum mit SiO₂ aufgefüllt werden, das in einem CVD-Verfahren unter Verwendung eines mindestens O₃ und Si(OC₂H₅)₄ enthaltenden Prozeßgases abgeschieden wird. Bei Verwendung eines O₃ und Si(OC₂H₅)₄ enthaltenden Prozeßgases in einem CVD-Verfahren können enge Gräben mit hohem Aspektverhältnis lunkerfrei aufgefüllt werden.

Weitere Ausgestaltungen der Erfindung gehen aus den übrigen Ansprüchen hervor.

Im folgenden wird die Erfindung anhand eines Ausführungsbeispiels und der Figuren näher erläutert.
- Figur 1: zeigt ein SOI-Substrat mit einer Grabenmaske.
- Figur 2: zeigt das SOI-Substrat nach der Grabenätzung.
- Figur 3: zeigt das SOI-Substrat nach Abscheidung einer Belegungsschicht und Bildung von dem Graben benachbarten Diffusionsgebieten.
- Figur 4: zeigt das SOI-Substrat nach der Entfernung der Belegungsschicht an den Seitenwänden und am Boden des Grabens.
- Figur 5: zeigt das SOI-Substrat nach vollständiger Entfernung der Belegungsschicht.
- Figur 6: zeigt das SOI-Substrat nach Abscheidung einer SiO₂-Schicht und einer Siliziumschicht.
- Figur 7: zeigt das SOI-Substrat nach der Bildung von Siliziumspacern.
- Figur 8: zeigt das SOI-Substrat nach der thermischen Oxidation der Siliziumspacer.
- Figur 9: zeigt das SOI-Substrat nach Auffüllen des Freiraums zwischen der Isolationsstruktur mit einer Siliziumfüllung.
- Figur 10: zeigt das SOI-Substrat nach Aufoxidation der Siliziumfüllung.

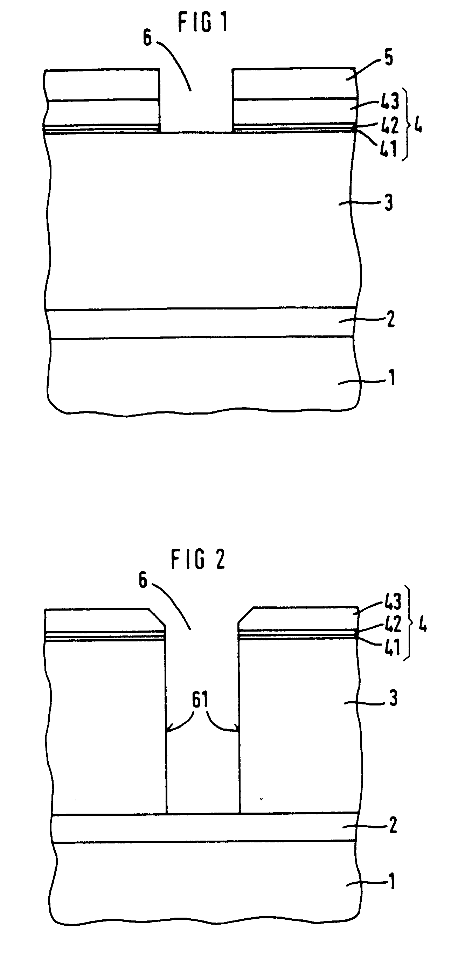

Ein SOI-Substrat umfaßt ein monokristallines Siliziumsubstrat 1, eine isolierende Schicht 2 und eine monokristalline Siliziumschicht 3 (siehe Figur 1). Das monokristalline Siliziumsubstrat ist zum Beispiel p⁺-dotiert mit einer Dotierstoffkonzentration von zum Beispiel 5 x 10¹⁹ Bor/cm³. Die isolierende Schicht 2 besteht aus SiO₂ und weist eine Dicke von zum Beispiel 2 µm auf. Die monokristalline Siliziumschicht 3 ist zum Beispiel schwach n-dotiert mit einer Dotierstoffkonzentration von zum Beispiel 4 x 10¹⁴ Phosphor/cm³ und weist eine Dicke von zum Beispiel 20 µm auf. Das SOI-Substrat ist vorzugsweise nach dem direct wafer bonding (DWB) oder silicon direct bonding (SDB)-Verfahren, das zum Beispiel aus Yu Ohata et al, IEEE 1987 CICC, S. 443 bis 446, bekannt ist, hergestellt.

Auf der Oberfläche der monokristallinen Siliziumschicht 3 wird eine Grabenmaske 4 gebildet. Dazu wird die Oberfläche der monokristallinen Siliziumschicht 3 zunächst thermisch oxidiert, wobei eine untere Schicht 41 aus thermischem SiO_{**2**} mit einer Dicke von zum Beispiel 50 nm entsteht. Darauf wird eine mittlere Schicht 42 aus einem CVD-Si₃N₄ in einer Dicke von zum Beispiel 150 nm hergestellt. Auf die mittlere Schicht 42 wird eine obere Schicht 43 aus einem CVD-SiO₂ in einer Dicke von zum Beispiel 1000 bis 1600 nm abgeschieden. Die Schichtenfolge bestehend aus der unteren Schicht 41, der mittleren Schicht 42 und der oberen Schicht 43 wird unter Verwendung einer Photolackmaske 5 zum Beispiel in einem CHF₃/O₂-Trockenätzprozeß strukturiert.

Nach Entfernen der Photolackmaske 5 wird ein Graben 6 in die monokristalline Siliziumschicht 3 geätzt (siehe Figur 2). Die Ätzung des Grabens 6 erfolgt zum Beispiel in einem anisotropen Trockenätzprozeß mit einer Cl₂/O₂-Chemie. Nach Entfernen von Ätzprodukten in einem HF-Dip liegt der Graben 6 mit sauberen Seitenwänden 61 auf dem SOI-Substrat vor.

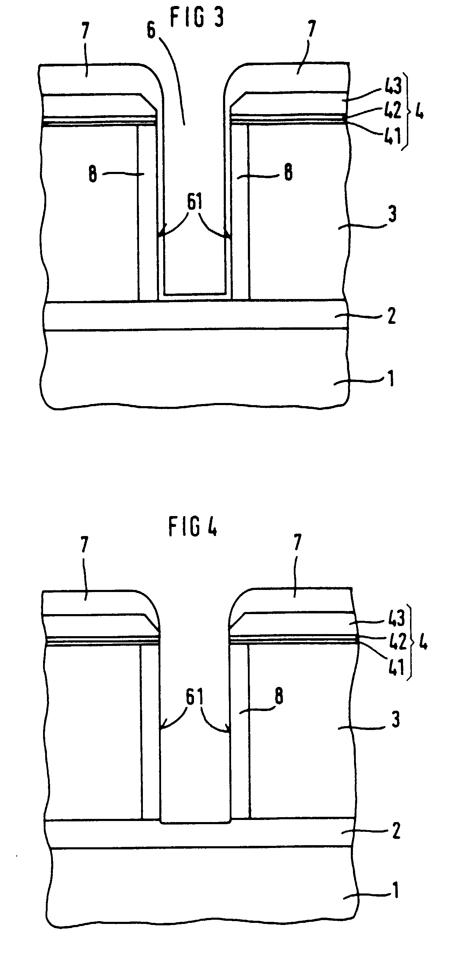

Auf die Oberfläche der monokristallinen Siliziumschicht 3 mit dem Graben 6 wird in einem CVD-Verfahren bei Atmosphärendruck (APCVD) eine Belegungsschicht 7 aus dotiertem Glas aufgebracht. Die Belegungsschicht 7 besteht zum Beispiel aus Borsilikatglas (BSG) mit vier Gewichtsprozent Bor. Die Belegungsschicht 7 wird in einer solchen Dicke abgeschieden, das oberhalb der Grabenmaske 4 eine Dicke von zum Beispiel 800 bis 1600 nm, vorzugsweise 1600 nm aufweist. Wegen der mangelhaften Konformität der Abscheidung beträgt die Dicke der Belegungsschicht an den Seitenwänden 61 und dem Boden des Grabens 6 dann 100 bis 200 nm (siehe Figur 3). Der auf den Seitenwänden 61 des Grabens 6 angeordnete Teil der Belegungsschicht 7 dient als Diffusionsquelle.

In einem Temperaturschritt bei zum Beispiel 1000°C während zum Beispiel 30 Minuten wird Dotierstoff aus der Belegungsschicht 7 durch die Seitenwände 61 des Grabens 6 in die monokristalline Siliziumschicht 3 eingetrieben, wobei ein dem Graben 6 benachbartes Diffusionsgebiet 8 entsteht. Bei dem Temperaturschritt zerfließt die Belegungsschicht, so daß ein nach dem Abscheiden entstandener Überhang im Bereich der Grabenmaske 4 verschwindet und sich im Bereich des Grabens 6 senkrechte Flanken der Belegungsschicht 7 ausbilden.

In einer isotropen, naßchemischen Ätzung zum Beispiel mit Flußsäure in einem HF-Dip, wird der auf den Seitenwänden 61 und dem Boden des Grabens 6 angeordnete Teil der Belegungsschicht 7 entfernt (siehe Figur 4). In diesem Ätzschritt wird die Oberfläche der isolierenden Schicht 2 des SOI-Substrats angegriffen. Es kommt zu einer lateralen Unterätzung der isolierenden Schicht 2 unter die monokristalline Schicht 3 von wenigen Nanometer. Die isotrope naßchemische Ätzung muß solange durchgeführt werden, bis der auf den Seitenwänden 61 und dem Boden des Grabens 6 angeordnete Teil der Belegungsschicht 7 entfernt ist.

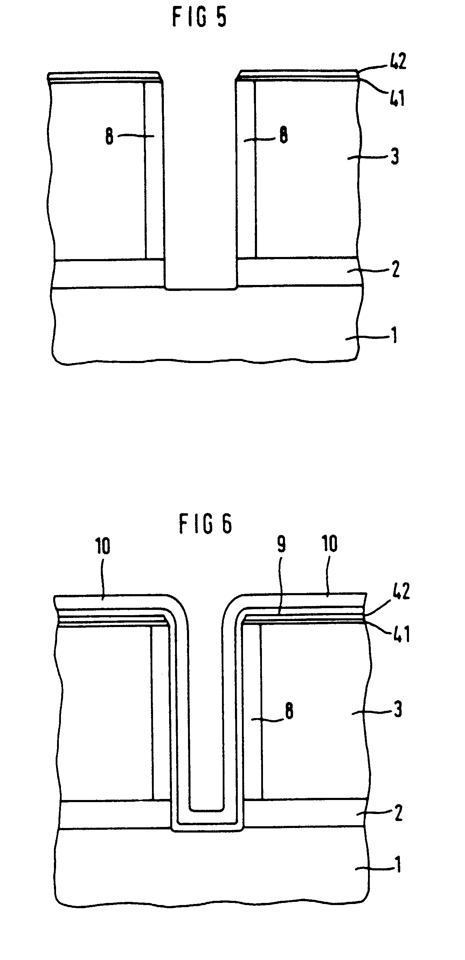

Der an der Oberfläche der Grabenmaske 4 angeordnete Teil der Belegungsschicht 7 wird mit Hilfe einer anisotropen Trockenätzung entfernt. Die anisotrope Trockenätzung erfolgt zum Beispiel mit CHF₃/O₂. Bei der anisotropen Trockenätzung wird gleichzeitig die isolierende Schicht 2 des SOI-Substrats und die obere Schicht 43 der Grabenmaske 4 weggeätzt (siehe Figur 5). Die anisotrope Trockenätzung wird selektiv zu Silizium durchgeführt. Dadurch wird ein Anätzen der Oberfläche des monokristallinen Siliziumsubstrats 1 des SOI-Substrats weitgehend vermieden.

Im folgenden wird zum Beispiel eine SiO₂-Schicht 9 aufgebracht, die eine Dicke von zum Beispiel 200 nm aufweist. Die SiO₂-Schicht 9 wird mit konformer Kantenbedeckung aufgebracht. Sie wird zum Beispiel in einem LPCVD-Verfahren durch Zersetzung von Si(OC₂H₅)₄ (TEOS) gebildet. Auf die SiO₂-Schicht 9 wird eine Siliziumschicht 10 abgeschieden. Die Siliziumschicht wird mit im wesentlichen konformer Kantenbedeckung in einer Dicke von zum Beispiel 400 nm in einem LPCVD-Verfahren hergestellt (siehe Figur 6). Die Siliziumschicht 10 wird undotiert amorph abgeschieden. Die Schichtdicken der SiO₂-Schicht 9 und der Siliziumschicht 10 werden auf die Grabenweite angepaßt. Sie müssen für die vorgegebene Grabengeometrie optimiert werden. Die Grabenweite beträgt in diesem Ausführungsbeispiel zum Beispiel 2 µm.

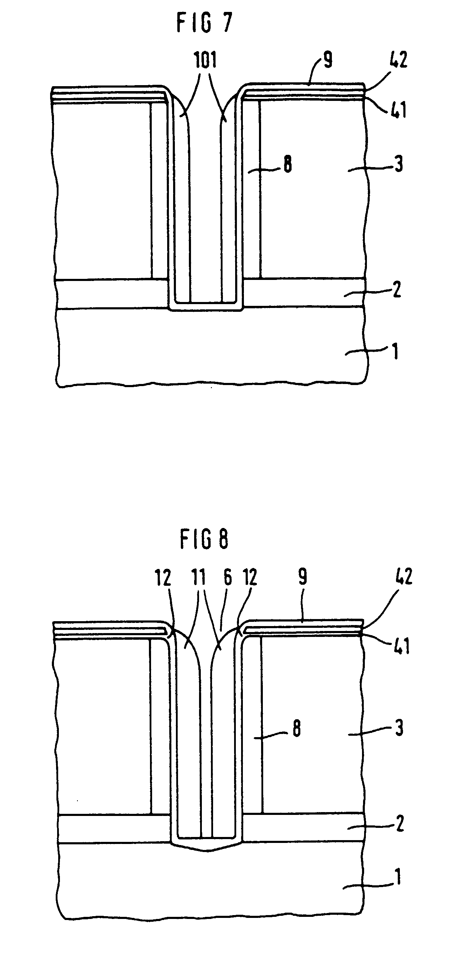

In einem anisotropen Ätzprozeß selektiv zu SiO₂ wird anschließend die Siliziumschicht 10 geätzt, bis waagerechte Oberflächen der SiO₂-Schicht 9 freigelegt werden. Dabei bilden sich an den Seitenwänden des Grabens 6 Siliziumspacer 101 (siehe Figur 7). Die anisotrope Ätzung erfolgt zum Beispiel in einer HBr/Cl₂-Chemie.

Anschließend wird eine thermische Oxidation durchgeführt. Diese erfolgt zum Beispiel bei 1000° in feuchter Atmosphäre. Dabei werden die Siliziumspacer 101 zu SiO₂ oxidiert und bilden eine Isolationsstruktur 11. Bei der Oxidation kommt es zu einer Volumenvergrößerung (siehe Figur 8). Gleichzeitig wird im Bereich des Bodens des Grabens 6 die SiO₂-Schicht 9 verstärkt. Im Bereich der Kante der unteren Schicht 41 der Grabenmaske 4 kommt es durch Aufoxidation zur Ausbildung eines Vogelschnabels 12.

In Anwendungen, in denen die Verstärkung der SiO₂-Schicht 9 im Bereich des Bodens des Grabens und die Ausbildung des Vogelschnabels 12 an der Oberkante des Grabens vermieden werden soll, kann anstelle der SiO₂-Schicht 9 eine Si₃N₄-Schicht oder eine Doppelschicht aus SiO₂ und Si₃N₄ an der Oberfläche verwendet werden.

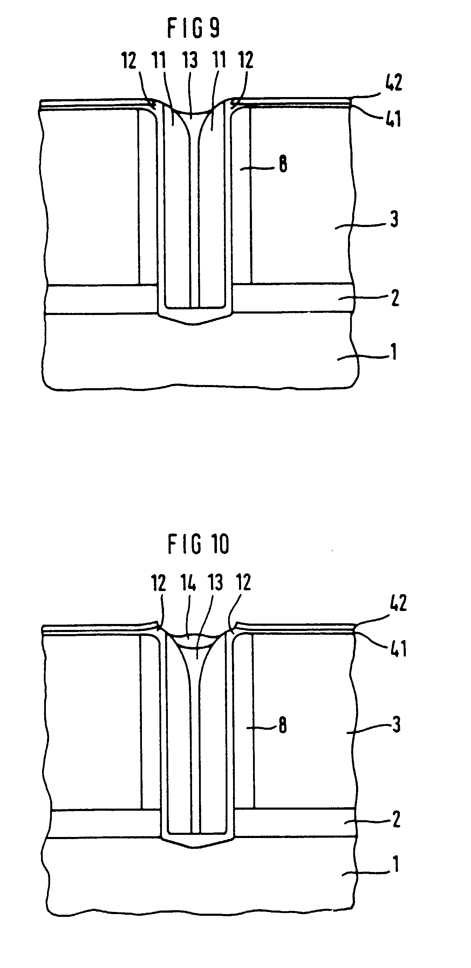

Zwischen gegenüberliegenden Flanken der Isolationsstruktur 11 verbliebener Freiraum wird durch Abscheidung einer weiteren Siliziumschicht und Rückätzung der Siliziumschicht mit einer Siliziumfüllung 13 aufgefüllt (siehe Figur 9). Die Rückätzung der weiteren Siliziumschicht wird so ausgelegt, daß die Siliziumfüllung 13 in der Höhe in etwa mit der unteren Schicht 41 der Grabenmaske 4 abschließt. In einer zu Si₃N₄ selektiven Ätzung werden anschließend freiliegende Teile der SiO₂-Schicht 9 entfernt. Die Ätzung wird solange fortgesetzt, bis die Oberfläche der mittleren Schicht 42 der Grabenmaske 4 freigelegt wird (siehe Figur 9).

In einer thermischen Oxidation bei zum Beispiel 1000°C in feuchter Atmosphäre wird die Oberfläche der Siliziumfüllung 13 aufoxidiert. Dabei bildet sich ein Isolationsabschluß 14, der die Siliziumfüllung 13 vollständig abdeckt (siehe Figur 10). Gleichzeitig vergrößert sich der Vogelschnabel 12. Der Vogelschnabel 12 trägt durch Kantenverrundung zur Erhöhung der Durchbruchsspannung bei.

Anschließend werden im Rahmen von Planarprozessen die Bauelemente in der monokristallinen Siliziumschicht 3 hergestellt.

Der in Figur 8 dargestellte Freiraum zwischen gegenüberliegenden Flanken der Isolationsstruktur 11 kann alternativ aufgefüllt werden durch konforme Abscheidung von SiO₂ vorzugsweise in einem CVD-Verfahren unter Verwendung von O₃ und Si(OC₂H₅)₄ als Ausgangsprozeßgas.

In dem erfindungsgemäßen Verfahren werden nur konventionelle Verfahren zur Grabendotierung und Grabenfüllung aus der CMOS-Fertigung verwendet. Da die CMOS-Fertigung zur Herstellung der Logikbauelemente ohnehin notwendig ist wird dabei ein Synergieeffekt ausgenützt.

Da das erfindungsgemäße Verfahren unempfindlich gegenüber An- und Durchätzen der isolierenden Schicht des SOI-Substrats ist, ist ein größeres Prozeßfenster möglich.

Durch den selbstjustierten Isolationsabschluß an der Oberfläche des Grabens bei gleichzeitiger Kantenverrundung und Vogelschnabel werden verbesserte elektrische Eigenschaften erzielt.

## Patentansprüche

1. Verfahren zur Herstellung eines Isolationsgrabens in einem SOI-Substrat, in dem Logikbauelemente und Hochspannungs-Leistungsbauelemente integriert sind,
- bei dem das SOI-Substrat eine monokristalline Siliziumscheibe (1), eine darauf angeordnete isolierende Schicht (2) aus SiO₂ und eine darauf angeordnete monokristalline Siliziumschicht (3) umfaßt,
- bei dem in die monokristalline Siliziumschicht (3) ein Graben (6) geätzt wird, der bis auf die isolierende Schicht (2) reicht,
- bei dem in einem CVD-Verfahren bei Atmosphärendruck (APCVD) die Seitenwände des Grabens (6) mit einer Dotierstoff enthaltenden Belegungsschicht (7) aus dotiertem Glas versehen werden,
- bei dem ein Temperaturschnitt durchgeführt wird, bei dem durch Ausdiffusion aus der Belegungsschicht (7) in der monokristallinen Siliziumschicht (3) dem Graben (6) benachbarte Diffusionsgebiete (8) erzeugt werden und bei dem die Belegungsschicht (7) zerfließt,
- bei dem die Belegungsschicht (7) in einem Ätzprozeß vollständig entfernt wird, bei dem die isolierende Schicht (2) angegriffen wird,
- bei dem eine Siliziumschicht (10) mit im wesentlichen konformer Kantenbedeckung abgeschieden wird,
- bei dem die Siliziumschicht (10) zur Bildung von Siliziumspacern (101) in einem anisotropen Ätzprozeß geätzt wird,
- bei dem durch eine thermische Oxidation der Siliziumspacer (101) eine Isolationsstruktur (11) im Graben (6) erzeugt wird.

2. Verfahren nach Anspruch 1,bei dem die thermische Oxidation im Temperaturbereich zwischen 900 und 1200°C in feuchter Atmosphäre erfolgt.

3. Verfahren nach Anspruch 1 oder 2,
bei dem die Siliziumschicht (10) amorph abgeschieden wird.

4. Verfahren nach einem der Ansprüche 1 bis 3,
- bei dem nach Entfernen der Belegungsschicht (7) eine isolierende Schicht (9), die mindestens eine der Verbindungen SiO₂ oder Si₃N₄ enthält, mit im wesentlichen konformer Kantenbedeckung erzeugt wird, auf deren Oberfläche die Siliziumschicht (10) aufgebracht wird,
- bei dem die Siliziumschicht (10) in einem anisotropen Ätzprozeß selektiv zu der isolierenden Schicht (9) geätzt wird, wobei waagerechte Flächen der isolierenden Schicht (9) freigelegt werden und wobei an senkrechten Flanken der monokristallinen Siliziumschicht (3) Siliziumspacer (101) verbleiben.

5. Verfahren nach Anspruch 4,
bei dem durch Abscheiden und Rückätzen einer weiteren Siliziumschicht verbliebener Freiraum innerhalb der Isolationsstruktur (11) im Graben (6) mit einer Siliziumfüllung (13) aufgefüllt wird.

6. Verfahren nach Anspruch 5,
- bei dem der Graben (6) unter Verwendung einer Grabenmaske (4), die als Schichtenfolge aus einer unteren Schicht (41) aus thermischem SiO₂, einer mittleren Schicht (42) aus CVD-Si₃N₄ und einer oberen Schicht (43) aus CVD SiO₂ gebildet wird, geätzt wird,
- bei dem die obere Schicht (43) der Grabenmaske (4) beim Entfernen der Belegungsschicht ebenfalls entfernt wird,
- bei dem das Rückätzen der weiteren Siliziumschicht so ausgelegt wird, daß die Siliziumfüllung (13) unterhalb der unteren Schicht (41) der Grabenmaske (4) abschließt,
- bei dem die Oberfläche der Siliziumfüllung (13) aufoxidiert wird, so daß ein Isolationsabschluß (11) entsteht, der die Siliziumfüllung (13) vollständig abdeckt.

7. Verfahren nach Anspruch 6,
bei dem die Aufoxidation der Siliziumfüllung (13) im Temperaturbereich zwischen 900°C und 1200°C in feuchter Atmosphäre erfolgt.

8. Verfahren nach Anspruch 4,
bei dem in einem CVD-Verfahren unter Verwendung eines mindestens O₃ und Si (OC₂H₅)₄ enthaltenden Prozeßgases verbliebener Freiraum innerhalb der Isolationsstruktur (11) im Graben (6) mit einer SiO₂-Füllung aufgefüllt wird.

## Claims

1. Process for producing an insulation trench in an SOI substrate in which logic components and high-voltage power components are integrated,
- in which the SOI substrate comprises a monocrystalline silicon wafer (1), an insulating layer (2) of SiO₂ which is arranged thereon, and a monocrystalline silicon layer (3) arranged on the latter,
- in which a trench (6), which extends as far as the insulating layer (2), is etched into the monocrystalline silicon layer (3),
- in which, in an atmospheric-pressure CVD process (APCVD), the side walls of the trench (6) are provided with a doped-glass application layer (7) containing a dope and,
- in which a heat-treatment step is carried out, in which diffusion regions (8) next to the trench (6) are produced in the monocrystalline silicon layer (3) by diffusion out from the application layer (7), and in which the application layer (7) is liquified,
- in which the application layer (7) is fully removed in an etching process, in which the insulating layer (2) is attacked,
- in which a silicon layer (10) having essentially conformal edge coverage is deposited,
- in which the silicon layer (10) is etched in an anisotropic etching process in order to form silicon spacers (101),
- in which, by thermal oxidation of the silicon spacers (101), an insulation structure (11) is produced in the trench (6).

2. Process according to Claim 1, in which the thermal oxidation is carried out in a temperature range of between 900 and 1200°C in a humid atmosphere.

3. Process according to Claim 1 or 2, in which the silicon layer (10) is amorphously deposited.

4. Process according to one of Claims 1 to 3,
- in which, after the application layer (7) has been removed, an insulating layer (9), which contains at least one of the compounds SiO₂ or Si₃N₄, is produced with essentially conformal edge coverage, and the silicon layer (10) is applied on its surface,
- in which the silicon layer (10) is etched selectively with respect to the insulating layer (9) in an anisotropic etching process, the horizontal faces of the insulating layer (9) being exposed, and silicon spacers (101) being left on perpendicular flanks of the monocrystalline silicon layer (3).

5. Process according to Claim 4, in which, by depositing and etching back a further silicon layer, any cavity remaining inside the insulation structure (11) in the trench (6) is filled with a silicon filler (13).

6. Process according to Claim 5,
- in which the trench (6) is etched by using a trench mask (4) which is formed as a layer sequence consisting of a lower layer (41) of thermal SiO₂, a central layer (42) of CVD Si₃N₄ and an upper layer (43) of CVD SiO₂,
- in which the upper layer (43) of the trench mask (4) is also removed when the application layer is removed,
- in which the further silicon layer is etched back in such a way that the silicon filler (13) terminates below the lower layer (41) of the trench mask (4),
- in which the surface of the silicon filler (13) is oxidized so as to produce an insulation seal (11) which fully covers the silicon filler (13).

7. Process according to Claim 6, in which the silicon filler (13) is oxidized in a temperature range of between 900°C and 1200°C in a humid atmosphere.

8. Process according to Claim 4, in which, in a CVD process with the use of a process gas containing at least O₃ and Si(OC₂H₅)₄, any cavity remaining inside the insulation structure (11) in the trench (6) is filled with an SiO₂ filler.

## Revendications

1. Procédé de fabrication d'une tranchée d'isolation dans un substrat SOI, dans lequel sont intégrés des composants logiques et des composants de puissance à haute tension,
- dans lequel le substrat SOI comprend une tranche de silicium monocristallin (1), une couche isolante (2) superposée, constituée de SiO₂ et une couche de silicium monocristallin (3) superposée,
- dans lequel on grave une tranchée (6) dans la couche de silicium monocristallin (3), tranchée qui s'étend jusqu'à la couche isolante (2),
- dans lequel on pourvoit des parois latérales de la tranchée (6) d'une couche de dépôt (7) constituée d'un verre dopé, contenant l'agent de dopage, au cours d'un procédé CVD sous pression atmosphérique (APCVD),
- dans lequel on effectue une étape thermique, au cours de laquelle on forme, par exodiffusion à partir de la couche de dépôt (7) dans la couche de silicium monocristallin (3), des régions de diffusion (8) adjacentes à la tranchée (6) et au cours de laquelle la couche de dépôt (7) se liquéfie,
- dans lequel la couche de dépôt (7) est enlevée complètement dans un procédé de gravure, au cours duquel la couche isolante (2) est attaquée,
- dans lequel une couche de silicium (10) avec un recouvrement d'arêtes essentiellement conforme est déposée,
- dans lequel la couche de silicium (10) est gravée au cours d'un procédé de gravure anisotrope en vue de la formation de spacers de silicium (101),
- dans lequel on crée, par une oxydation thermique des spacers de silicium (101), une structure d'isolation (11) dans la tranchée (6).

2. Procédé selon la revendication 1, dans lequel l'oxydation thermique est effectuée dans une gamme de températures entre 900 et 1.200 °C dans une atmosphère humide.

3. Procédé selon la revendication 1 ou 2, dans lequel la couche de silicium (10) est déposée sous forme amorphe.

4. Procédé selon l'une des revendications 1 à 3,
- dans lequel on crée, après l'enlèvement de la couche de dépôt (7), une couche isolante (9) qui contient au moins un des composés SiO₂ ou Si₃N₄, avec un recouvrement d'arêtes essentiellement conforme, à la surface de laquelle on applique la couche de silicium (10),
- dans lequel la couche de silicium (10) est gravée au cours d'un procédé de gravure anisotrope, sélectif par rapport à la couche isolante (9), au cours duquel on dégage des surfaces horizontales de la couche isolante (9) et au cours duquel il subsiste sur les flancs verticaux de la couche de silicium monocristallin (3) des spacers de silicium (101).

5. Procédé selon la revendication 4, dans lequel on remplit l'espace libre subsistant après le dépôt et après la regravure d'une couche de silicium supplémentaire, à l'intérieur de la structure d'isolation (11) dans la tranchée (6) avec un remplissage de silicium (13).

6. Procédé selon la revendication 5,
- dans lequel la tranchée (6) est gravée en utilisant un masque de tranchée (4), qui est formé d'une couche inférieure (41) constituée de SiO₂ thermique, d'une couche moyenne (42) constituée de Si₃N₄ déposé par CVD et d'une couche supérieure (43) constituée de SiO₂ déposé par CVD, à titre de séquence de couches,
- dans lequel la couche supérieure (43) du masque de tranchée (4) est également enlevée lors de l'enlèvement de la couche de dépôt,
- dans lequel la regravure de la couche de silicium supplémentaire est effectuée de telle manière que le remplissage de silicium (13) se termine en dessous de la couche inférieure (41) du masque de tranchée (4),
- dans lequel la surface du remplissage de silicium (13) est oxydée, de telle manière qu'il se forme une extrémité d'isolation (14), qui recouvre entièrement le remplissage de silicium (13).

7. Procédé selon la revendication 6, dans lequel l'oxydation du remplissage de silicium (13) est effectuée dans une gamme de températures entre 900 °C et 1.200 °C dans une atmosphère humide.

8. Procédé selon la revendication 4, dans lequel on remplit l'espace libre subsistant après un procédé CVD utilisant un gaz de procédé contenant au moins du O₃ et du Si(OC₂H₅)₄ à l'intérieur de la structure d'isolation (11) dans la tranchée (6) avec un remplissage de SiO₂.
